(19) **Europäisches Patentamt / European Patent Office / Office européen des brevets**

(11) **EP 4 004 986 B1**

(12) # FASCICULE DE BREVET EUROPEEN

(45) Date de publication et mention
de la délivrance du brevet:
**08.10.2025 Bulletin 2025/41**

(21) Numéro de dépôt: **20750195.8**

(22) Date de dépôt: **24.07.2020**

(51) Classification Internationale des Brevets (IPC):
**H10F 10/166** (2025.01)   **H10F 77/166** (2025.01)
**H10F 71/10** (2025.01)

(52) Classification Coopérative des Brevets (CPC):
**H10F 10/166; H10F 71/10; H10F 77/1668;**
Y02E 10/50; Y02P 70/50

(86) Numéro de dépôt international:
**PCT/EP2020/070914**

(87) Numéro de publication internationale:
**WO 2021/018757 (04.02.2021 Gazette 2021/05)**

(54) **PROCÉDÉ DE TRAITEMENT D'UN EMPILEMENT OBTENU LORS DE LA FABRICATION D'UNE CELLULE PHOTOVOLTAÏQUE A HÉTÉROJONCTION**

VERFAHREN ZUR BEHANDLUNG EINES BEI DER HERSTELLUNG EINER HETEROÜBERGANGSFOTOVOLTAIKZELLE ERHALTENEN STAPELS

METHOD FOR TREATING A STACK OBTAINED DURING THE MANUFACTURE OF A HETEROJUNCTION PHOTOVOLTAIC CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.07.2019 FR 1908538**

(43) Date de publication de la demande:
**01.06.2022 Bulletin 2022/22**

(73) Titulaire: **Commissariat à l'Energie Atomique et aux Energies Alternatives**
**75015 Paris (FR)**

(72) Inventeurs:
• **VEIRMAN, Jordi**
**38054 Grenoble Cedex 09 (FR)**

• **STENDERA, Julie**
**38054 Grenoble Cedex 09 (FR)**

(74) Mandataire: **Cabinet Camus Lebkiri**
**25 rue de Maubeuge**
**75009 Paris (FR)**

(56) Documents cités:
**WO-A1-2013/001440    WO-A1-2020/082131**

• **SUN CHANG ET AL: "Complete regeneration of BO-related defects in n-type upgraded metallurgical-grade Czochralski-grown silicon heterojunction solar cells", APPLIED PHYSICS LETTERS, A I P PUBLISHING LLC, US, vol. 113, no. 15, 12 October 2018 (2018-10-12), XP012232335, ISSN: 0003-6951, [retrieved on 20181012], DOI: 10.1063/1.5042460**

EP 4 004 986 B1

## Description

## DOMAINE TECHNIQUE

La présente invention concerne un procédé de traitement d'un empilement obtenu lors de la fabrication d'une cellule photovoltaïque à hétérojonction, afin d'améliorer et stabiliser le rendement de la cellule photovoltaïque. L'invention concerne également un procédé de fabrication de cellules photovoltaïques à hétérojonction.

## ÉTAT DE LA TECHNIQUE

Une cellule photovoltaïque à hétérojonction est un dispositif capable d'absorber le rayonnement solaire et de le convertir en énergie électrique. Un tel dispositif comprend une jonction p-n formée par la superposition de deux matériaux semi-conducteurs ayant des largeurs de bande interdite différentes, tels que le silicium cristallin et le silicium amorphe.

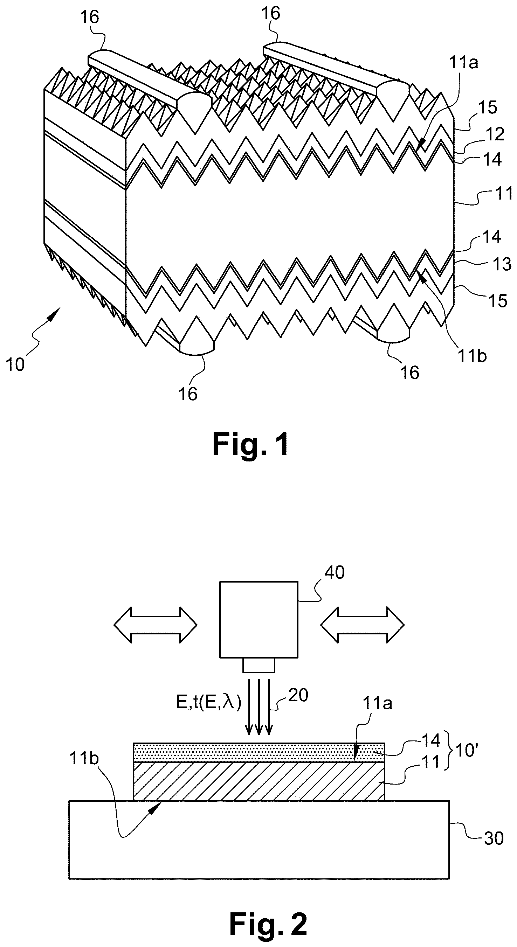

La figure 1 représente un exemple de cellule photovoltaïque 10 à hétérojonction de silicium (SHJ). La cellule photovoltaïque 10 comprend un substrat 11 en silicium cristallin dopé et deux couches de silicium amorphe 12-13 disposées de part et d'autre du substrat 11. L'une des couches de silicium amorphe 12-13 est dopée du même type de conductivité que le substrat 11, par exemple de type n, et l'autre couche est dopée du type de conductivité opposé, c'est-à-dire de type p.

L'hétérojonction est formée par le substrat 11 en silicium cristallin dopé n et la couche de silicium amorphe dopé p, cette couche formant l'émetteur de la cellule photovoltaïque. L'émetteur peut être situé en face avant ou en face arrière de la cellule photovoltaïque.

La cellule photovoltaïque SHJ est particulièrement sensible aux défauts situés à l'interface entre le substrat 11 en silicium cristallin et les couches de silicium amorphe 12-13. Ces défauts peuvent être des liaisons pendantes, également appelées « dangling bonds » en anglais, ou des impuretés telles que des ions métalliques. Ils introduisent des niveaux d'énergie dans la bande interdite du silicium et augmentent le nombre de recombinaisons électron-trou aux interfaces, ce qui détériore les paramètres de sortie de la cellule photovoltaïque, tels que la tension en circuit ouvert Voc.

Pour obtenir une cellule photovoltaïque performante, il est donc nécessaire de minimiser le nombre de recombinaisons en surface du substrat 11, ce qui est généralement accompli en déposant une couche de passivation 14 en silicium amorphe hydrogéné intrinsèque sur chacune des faces du substrat 11, avant la couche de silicium amorphe 12, 13. Les atomes d'hydrogène contenus dans les couches de passivation 14 diffusent jusqu'à la surface du substrat 11 et neutralisent les défauts.

Chacune des couches de silicium amorphe 12-13 est par ailleurs recouverte d'une couche d'oxyde transparent conducteur (ou TCO, pour « Transparent Conductive Oxide » en anglais) 15.

Les cellules photovoltaïques SHJ sont connues pour voir leur rendement de conversion énergétique s'améliorer d'environ 0,3 % absolu sous l'action conjuguée de l'éclairement et de la température. Ce phénomène de « bonification » des cellules résulte de l'amélioration d'au moins une des couches de passivation 14 en silicium amorphe hydrogéné, ainsi que de l'amélioration des interfaces entre les couches de silicium amorphe 12-13 et les couches de TCO 15.

Le document WO2013/001440 décrit un exemple de procédé de traitement de cellule photovoltaïque SHJ comprenant un substrat en silicium cristallin dopé n. Dans ce procédé de traitement, la cellule photovoltaïque est soumise à un flux lumineux d'irradiance supérieure ou égale à 500 W/m$^2$ pendant une durée d'environ 10 heures, tout en étant chauffée à une température comprise entre 20 °C et 200 °C. Une telle durée de traitement est incompatible avec la cadence des lignes de production actuelles de cellules photovoltaïques.

Par ailleurs, le document [« Complete regeneration of BO-related defects in n-type upgraded metallurgical-grade Czochralski-grown silicon heterojunction solar cells », C. Sun et al., Appl. Phys. Lett. 113, 152105, 2018] décrit un procédé de régénération de cellules photovoltaïques à hétérojonction réalisées à partir de substrats en silicium de qualité métallurgique (ou UMG, pour « upgraded metallurgical-grade » en anglais). Ce type de matériau contient de grandes quantités d'atomes de bore et d'oxygène qui sont à l'origine de la formation de défauts et d'une dégradation de la tension de circuit ouvert Voc durant les premières heures de fonctionnement des cellules photovoltaïques. Le document montre que les cellules photovoltaïques retrouvent leur tension de circuit ouvert Voc initiale après 30 à 100 secondes d'exposition à un laser ayant une irradiance égale à 57 kW/m$^2$. Le phénomène observé dans ce document, spécifique aux cellules photovoltaïques à base de silicium de type n compensé avec du bore, est toutefois différent du phénomène recherché de bonification des cellules photovoltaïques, car il est précédé d'une phase de dégradation de la tension de circuit ouvert Voc.

## RÉSUMÉ DE L'INVENTION

Il existe donc un besoin de prévoir un procédé de traitement qui puisse être accompli à une cadence élevée lors de la fabrication des cellules photovoltaïques, de façon à être compatible avec des exigences de production industrielle.

Selon un premier aspect de l'invention, on tend à satisfaire ce besoin en prévoyant un procédé de traitement d'un empilement obtenu lors de la fabrication d'une cellule photovoltaïque à hétérojonction, l'empilement comprenant un substrat en silicium cristallin de type n et une couche de passivation en silicium amorphe hydrogéné disposée sur une face du substrat, ledit procédé comprenant une étape d'exposition de l'empilement à un rayonnement électromagnétique pendant une durée de traitement inférieure ou égale à 12 s, le rayonnement électromagnétique présentant une irradiance supérieure ou égale à 200 kW/m$^2$.

Une irradiance supérieure ou égale à 200 kW/m$^2$ associée à une durée de traitement inférieure ou égale à 12 s permet d'obtenir une amélioration du rendement de conversion de la cellule photovoltaïque tout en restant compatible avec des exigences de production industrielle. Une telle irradiance permet en outre de s'affranchir des moyens de chauffage utilisés dans le procédé de l'art antérieur, tels qu'une plaque chauffante.

Le procédé de traitement selon le premier aspect de l'invention peut également présenter une ou plusieurs des caractéristiques ci-dessous, considérées individuellement ou selon toutes les combinaisons techniquement possibles.

Dans un mode de mise en oeuvre, l'irradiance du rayonnement électromagnétique est supérieure ou égale à 300 kW/m$^2$ et la durée de traitement est inférieure ou égale à 8 s.

Dans un mode de mise en œuvre, l'irradiance du rayonnement électromagnétique est supérieure ou égale à 1000 kW/m$^2$ et la durée de traitement est inférieure ou égale à 2,5 s.

De préférence, la durée de traitement est inversement proportionnelle à l'irradiance du rayonnement électromagnétique.

Dans un mode de mise en œuvre, le rayonnement électromagnétique est monochromatique et présente une longueur d'onde comprise entre 400 nm et 1100 nm, de préférence entre 800 nm et 1000 nm.

Selon un développement de ce mode de mise en œuvre, la durée de traitement satisfait la relation suivante :

$$t \geq 0{,}23 \times \frac{1000}{E} \times \frac{980}{\lambda}$$

où $\lambda$ est la longueur d'onde du rayonnement électromagnétique et $E$ est l'irradiance du rayonnement électromagnétique.

De préférence, la durée de traitement satisfait en outre la relation suivante :

$$t \leq \frac{1000}{E} \times \frac{980}{\lambda}$$

Dans une variante de mise en œuvre, le rayonnement électromagnétique comprend plusieurs composantes de longueur d'onde comprise entre 400 nm et 1100 nm, de préférence entre 800 nm et 1000 nm.

Selon un développement de cette variante de mise en œuvre, la durée de traitement satisfait la relation suivante :

$$t \geq 0{,}23 \times \frac{1}{\sum_{i=1}^{n} \frac{E_i}{1000} \times \frac{\lambda_i}{980}}$$

où i est un indice variant entre 1 et le nombre n de composantes du rayonnement électromagnétique, $\lambda_i$ est la longueur d'onde de la composante d'indice i et $E_i$ est l'irradiance de la composante d'indice i.

De préférence, la durée de traitement satisfait en outre la relation suivante :

$$t \leq \frac{1}{\sum_{i=1}^{n} \frac{E_i}{1000} \times \frac{\lambda_i}{980}}$$

L'empilement est avantageusement maintenu à une température inférieure à 200 °C lors de l'étape d'exposition au rayonnement électromagnétique.

L'étape d'exposition au rayonnement électromagnétique peut être continue ou séquentielle.

Dans un mode de mise en œuvre, l'étape d'exposition au rayonnement électromagnétique comprend une pluralité de phases d'exposition de durée inférieure ou égale à 0,2 s, séparées par des phases de refroidissement, et l'empilement est maintenu à une température inférieure ou égale à 320 °C lors de chacune des phases d'exposition.

Avantageusement, le substrat présente une concentration en impuretés dopantes de type accepteur inférieure à 10$^{13}$ cm$^{-3}$, de préférence inférieure à 3.10$^{12}$ cm$^{-3}$.

Lorsque le substrat comporte des impuretés dopantes de type donneur et des impuretés dopantes de type accepteur, la concentration en impuretés dopantes de type donneur est de préférence supérieure à 50 fois la concentration en impuretés dopantes de type accepteur.

Un deuxième aspect de l'invention concerne un procédé de fabrication d'une cellule photovoltaïque à hétérojonction. Ce procédé de fabrication comprend les étapes suivantes :

- former un empilement en déposant une couche de passivation en silicium amorphe hydrogéné sur une face d'un substrat en silicium cristallin dopé de type n ;
- exposer l'empilement à un rayonnement électromagnétique pendant une durée de traitement inférieure ou égale à 12 s, le rayonnement électromagnétique présentant une irradiance supérieure ou égale à 200 kW/m$^2$.

Le procédé de fabrication selon le deuxième aspect de l'invention peut également présenter une ou plusieurs des caractéristiques ci-dessous, considérées individuellement ou selon toutes les combinaisons techniquement possibles.

Dans un mode de mise en œuvre, le procédé de fabrication comprend en outre une étape de dépôt d'une couche de silicium amorphe dopé sur la couche de passivation.

Selon un développement, l'empilement est exposé au rayonnement électromagnétique pendant le dépôt de la couche de silicium amorphe dopé.

Dans un mode de mise en œuvre, le procédé de fabrication comprend en outre une étape de dépôt d'une couche d'oxyde transparent conducteur sur la couche de silicium amorphe dopé.

Selon un développement, l'empilement est exposé au rayonnement électromagnétique pendant l'étape de dépôt de la couche d'oxyde transparent conducteur.

Dans un mode de mise en œuvre, le procédé de fabrication comprend en outre une étape de formation d'au moins une électrode sur la couche d'oxyde transparent conducteur, l'étape de formation de ladite au moins une électrode comprenant une opération de dépôt par sérigraphie d'une pâte métallique et une opération de durcissement de la pâte métallique.

Selon un développement, l'opération de durcissement de la pâte métallique et l'étape d'exposition au rayonnement électromagnétique sont accomplies simultanément.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures suivantes.

[Fig 1] est une vue schématique en perspective d'un exemple de cellule photovoltaïque à hétérojonction.

[Fig 2] représente schématiquement un procédé de traitement d'un empilement selon le premier aspect de l'invention

[Fig 3] montre l'amélioration du pseudo-rendement d'une cellule à hétérojonction de silicium dont l'empilement a été exposé à un rayonnement électromagnétique, pour plusieurs valeurs d'irradiance du rayonnement.

[Fig 4] représente différentes courbes caractéristiques d'une durée d'exposition au rayonnement électromagnétique en fonction de l'irradiance du rayonnement, ces différentes courbes correspondant à des rayonnements monochromatiques de longueurs d'onde différentes.

[Fig 5] montre l'évolution du pseudo-rendement de six cellules photovoltaïques à hétérojonction de silicium, après une exposition de 3 secondes à un rayonnement électromagnétique présentant une irradiance de 300 kW/m$^2$.

Pour plus de clarté, les éléments identiques ou similaires sont repérés par des signes de référence identiques sur l'ensemble des figures.

## DESCRIPTION DÉTAILLÉE

La figure 2 représente schématiquement un procédé de traitement d'un empilement 10' obtenu lors de la fabrication d'une cellule photovoltaïque à hétérojonction. L'empilement 10' comprend un substrat 11 en silicium cristallin (c-Si) dopé de type n et une première couche de passivation 14 disposée sur une première face 11a du substrat 11. L'empilement 10' peut être un précurseur de cellule photovoltaïque à hétérojonction, c'est-à-dire un produit intermédiaire obtenu au cours de la fabrication d'une cellule photovoltaïque à hétérojonction, ou une cellule photovoltaïque à hétérojonction finalisée (c.-à-d. prête à être interconnectée avec d'autres cellules photovoltaïques à hétérojonction).

Seules des impuretés dopantes de type donneur (par exemple des atomes de phosphore) ont été volontairement introduites dans le silicium cristallin du substrat 11 afin de modifier sa conductivité électrique. Outre des impuretés dopantes de type donneur, le substrat 11 peut contenir, de façon non intentionnelle (et donc à l'état de traces), des impuretés dopantes de type accepteur (telles que des atomes de bore). La concentration en impuretés dopantes de type accepteur $N_A$ du substrat 11 est avantageusement inférieure à $10^{13}$ $cm^{-3}$, de préférence inférieure à $3.10^{12}$ $cm^{-3}$. La concentration en impuretés dopantes de type donneur No est de préférence supérieure à 50 fois la concentration en impuretés dopantes de type accepteur $N_A$ (ou $N_D/N_A>50$).

La première couche de passivation 14 est en silicium amorphe hydrogéné (a-Si:H). Le silicium amorphe hydrogéné de la première couche de passivation 14 est de préférence intrinsèque, c'est-à-dire non intentionnellement dopé. Le silicium amorphe hydrogéné intrinsèque permet en effet une meilleure passivation chimique des surfaces de silicium cristallin que le silicium amorphe hydrogéné dopé.

En référence à la figure 2, le procédé de traitement comprend une étape d'exposition de l'empilement 10' à un rayonnement électromagnétique 20 pendant une durée de traitement t qui est avantageusement fonction de l'irradiance totale E du rayonnement électromagnétique 20 et de la longueur d'onde $\lambda$ (ou des longueurs d'onde) du rayonnement électromagnétique 20. L'irradiance E, appelée aussi éclairement énergétique ou densité surfacique de puissance lumineuse, représente la puissance du rayonnement électromagnétique reçue par une unité de surface, cette unité de surface étant orientée perpendiculairement à la direction du rayonnement électromagnétique.

L'étape d'exposition, aussi appelée étape d'illumination, peut être accomplie en disposant l'empilement 10' sur un support 30 et sous une source de rayonnement 40. Le rayonnement électromagnétique 20 (émis par la source 40) est de préférence dirigé perpendiculairement à la surface de l'empilement 10'.

L'exposition de l'empilement 10' au rayonnement électromagnétique 20 a pour effet de diminuer le nombre d'états d'interface entre le substrat cristallin 11 et la première couche de passivation 14. Autrement dit, le nombre de défauts d'interface neutralisés augmente et la qualité de la passivation s'améliore. Il en résulte une augmentation de la tension de circuit ouvert Voc et du facteur de forme (FF) de la cellule photovoltaïque et par conséquent une augmentation de son rendement de conversation.

Afin d'améliorer le rendement de conversion de la cellule, il n'est pas utile d'exposer plus d'une face de l'empilement 10' au rayonnement électromagnétique 20. En revanche, cette face de l'empilement 10' peut être illuminée entièrement. De préférence, toutes les régions de la face exposée de l'empilement 10' reçoivent le rayonnement électromagnétique 20 pendant la même durée de traitement t.

Les deux faces de l'empilement 10' peuvent être aussi exposées simultanément (en prévoyant deux source de rayonnement 40), par exemple pour diviser le temps de traitement par deux, ou successivement.

Le support 30 est par exemple un porte-substrat. Il peut être couplé à un système de refroidissement (non représenté), afin de maintenir la température de l'empilement 10' en dessous de 200 °C. En effet, après plusieurs secondes passées au-delà de cette température seuil, le silicium amorphe de la première couche de passivation 14 se dégrade de façon irrémédiable, entraînant une diminution des performances de la cellule photovoltaïque. Le support 30 est par exemple refroidi en faisant circuler un fluide caloporteur ou grâce à des éléments Peltier.

La source de rayonnement 40 peut être un système laser comprenant par exemple une ou plusieurs matrices de lasers, un ensemble de diodes électroluminescentes ou tout autre dispositif capable d'émettre un rayonnement électromagnétique d'une irradiance supérieure à 200 $kW/m^2$.

Un système de déplacement du support 30 ou de la source 40 peut être prévu afin d'animer le support 30 et la source 40 d'un mouvement relatif de translation. Un tel système de translation permet d'illuminer toute une face de l'empilement 10' dans le cas d'une source 40 ayant une surface d'illumination inférieure à la superficie de la face de l'empilement 10' (cas d'un système laser notamment). Il permet également d'illuminer plusieurs empilements 10' successivement, ces empilements étant par exemple disposés sur le même support.

Le rayonnement électromagnétique 20 peut être monochromatique, c'est-à-dire ne présenter qu'une seule longueur d'onde, ou polychromatique, c'est-à-dire comporter plusieurs composantes (monochromatiques) de longueurs d'ondes différentes. Plus précisément, le rayonnement électromagnétique 20 présente au moins une longueur d'onde comprise entre 400 nm et 1100 nm (dans cette plage, le rayonnement est absorbé au moins en partie dans le substrat cristallin de type n), préférentiellement entre 800 nm et 1000 nm.

La plage de longueur d'onde [800 nm-1000 nm] constitue un excellent compromis entre le flux de photons arrivant sur l'empilement 10' et la probabilité que ces photons soient absorbés par le substrat. En effet, plus la longueur d'onde est grande, moins les photons sont énergétiques et plus le flux de photons reçu par l'empilement est important à une irradiance donnée. Toutefois, la probabilité d'absorption des photons diminue fortement lorsque la longueur d'onde devient supérieure à 1000 nm. Un autre avantage à privilégier les grandes longueurs d'onde (800-1000 nm) tient du fait que les photons plus énergétiques (< 800 nm) transfèrent une partie de leur énergie sous forme de chaleur dans l'empilement, par émission de phonons. Or l'augmentation de température qui en résulte n'est pas souhaitable compte tenu du risque de dégradation du silicium amorphe.

L'empilement 10' comprend avantageusement une deuxième couche de passivation (non représentée sur la figure 2) disposée sur une deuxième face 11b du substrat 11, opposée à la première face 11a. La deuxième couche de passivation peut être en silicium amorphe hydrogéné intrinsèque, nitrure de silicium, oxyde d'aluminium, oxyde de titane ou oxyde de silicium. A l'instar de la première couche de passivation 14, la deuxième couche de passivation contribue à réduire le nombre de recombinaisons des paires électron-trou en surface du substrat 11, augmentant ainsi le niveau d'injection dans l'empilement 10' lors de l'étape d'illumination (et du fonctionnement ultérieur de la cellule photovoltaïque).

La première face 11a du substrat 11 (recouverte de la première couche de passivation 14) peut être tournée vers la source de rayonnement 40, comme cela illustré par la figure 2. Alternativement, la deuxième face 11b du substrat 11 peut être tournée vers la source de rayonnement 40.

L'empilement 10' peut également comprendre une couche de silicium amorphe dopé de type p (non représentée) destinée à former l'émetteur de la cellule photovoltaïque et disposée sur la première couche de passivation 14 ou la deuxième couche de passivation.

Dans un mode de mise en œuvre du procédé de traitement, l'empilement 10' est du type représenté sur la figure 1 et comprend :

- un substrat 11 en silicium cristallin dopé n ;
- une première couche de passivation 14 en silicium amorphe hydrogéné (et de préférence intrinsèque) disposée sur la première face 11a du substrat 11 ;
- une première couche de silicium amorphe 12, disposée sur la première couche de passivation 14 et dopée d'un premier type de conductivité ;
- une première couche d'oxyde transparent conducteur 15 disposée sur la première couche dopée de silicium amorphe 12 ;
- une deuxième couche de passivation 14 en silicium amorphe hydrogéné (et de préférence intrinsèque) disposée sur la deuxième face 11b du substrat 11 ;
- une deuxième couche de silicium amorphe 13, disposée sur la deuxième couche de passivation 14 et dopée d'un deuxième type de conductivité opposé au premier type de conductivité ; et
- une deuxième couche d'oxyde transparent conducteur 15 disposée sur la deuxième couche dopée de silicium amorphe 13.

Un tel empilement ou précurseur de cellule photovoltaïque à hétérojonction est qualifié d'asymétrique en raison des deux couches de silicium amorphe 12-13 dopées de types de conductivité opposés et disposées de part et d'autre du substrat 11. Le silicium amorphe de la première couche dopée 12 et/ou de la deuxième couche dopée 13 est de préférence hydrogéné.

Lorsqu'un empilement du type de la figure 1 est exposé au rayonnement électromagnétique 20, une diminution de la résistance série de la cellule photovoltaïque est en outre observée.

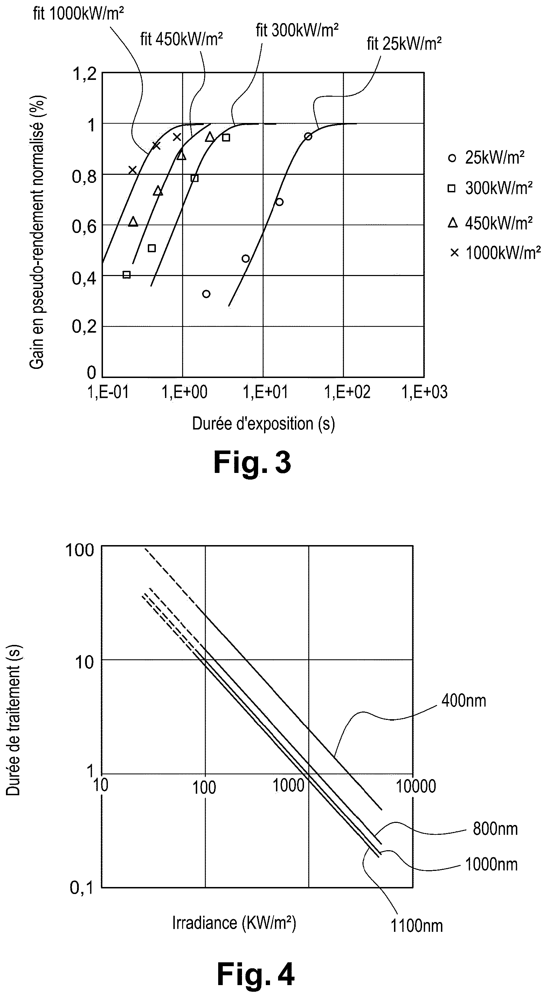

La figure 3 est un graphe représentant le gain en pseudo-rendement de conversion d'une cellule à hétérojonction de type n dont l'empilement a été exposé à un rayonnement électromagnétique, en fonction de la durée d'exposition et pour plusieurs valeurs d'irradiance du rayonnement. Le pseudo-rendement de conversion correspond à une limite supérieure du rendement de conversion, car il ne tient pas compte des résistances série dans la cellule photovoltaïque. Les variations du pseudo-rendement sont supposées identiques aux variations du rendement lui-même. Sur la figure 3, le gain en pseudo-rendement est normalisé à sa valeur maximale : une valeur égale à 1 correspond donc à un gain en pseudo-rendement maximum. Le rayonnement électromagnétique est ici monochromatique et présente une longueur d'onde de 980 nm.

La figure 3 montre que la cinétique du gain en pseudo-rendement augmente avec l'irradiance du rayonnement. Un gain d'environ 95 % de sa valeur maximale est par exemple obtenu après seulement 3 secondes d'exposition à un rayonnement d'irradiance égale à 300 kW/m$^2$, contre 40 secondes pour un rayonnement d'irradiance égale à 25 kW/m$^2$.

Sur la figure 3, les valeurs expérimentales du gain normalisé associées à chaque valeur d'irradiance (25, 300, 400 et 1000 kW/m$^2$) ont été ajustées par une courbe (« fit »). Chaque courbe peut être décrite par une expression de la forme :

[Math 1]

$$Gain\ normalisé\ (t_e) = 1 - e^{-t_e/\tau}$$

où $t_e$ est la durée d'exposition et $\tau$ est une constante de temps.

On appelle ci-dessous « durée de traitement de référence $t_{ref}$ » la durée d'exposition permettant d'obtenir 95 % du gain maximal en pseudo-rendement.

[Math 2]

$$Gain\ normalisé\ (t_{ref}) = 0,95 = 1 - e^{-t_{ref}/\tau}$$

Une relation entre l'irradiance E du rayonnement électromagnétique 20 et la durée de traitement de référence $t_{ref}$ peut être établie en extrayant du graphe de la figure 3 les valeurs de durée d'exposition correspondant à gain normalisé égal à 0,95.

Dans le cas d'un rayonnement électromagnétique de longueur d'onde égale à 980 nm, la durée de traitement de référence $t_{ref}$ (en secondes) est de préférence donnée par l'expression suivante :

[Math 3]

$$t_{ref} = \frac{1000}{E}$$

où E est l'irradiance du rayonnement électromagnétique (i.e. la densité surfacique de puissance lumineuse) en kW/m$^2$.

Dans le cas plus général d'un rayonnement électromagnétique monochromatique de longueur d'onde $\lambda$ comprise entre 400 nm et 1100 nm, la durée de traitement de référence $t_{ref}$ (en secondes) est de préférence donnée par l'expression suivante :

[Math 4]

$$t_{ref} = \frac{1000}{E} \times \frac{980}{\lambda}$$

où E est l'irradiance du rayonnement électromagnétique en kW/m$^2$.

Ainsi, la durée de traitement de référence $t_{ref}$ est inversement proportionnelle à l'irradiance E du rayonnement électromagnétique 20.

Enfin, dans le cas d'un rayonnement électromagnétique 20 polychromatique comprenant plusieurs composantes (monochromatiques) de longueur d'onde comprise entre 400 nm et 1100 nm, la durée de traitement de référence $t_{ref}$ est donnée par la relation suivante :

[Math 5]

$$t_{ref} = \frac{1}{\sum_{i=1}^{n} \frac{E_i}{1000} \times \frac{\lambda_i}{980}}$$

où i un indice qui varie entre 1 et le nombre n de composantes (n étant un entier naturel supérieur ou égal à 2), $\lambda_i$ la longueur d'onde de la composante d'indice i et $E_i$ l'irradiance de la composante d'indice i. L'irradiance totale E définie plus haut est égale à la somme algébrique des irradiances $E_i$ des différentes composantes.

La figure 4 est un abaque comprenant plusieurs courbes caractéristiques de la durée de traitement de référence $t_{ref}$ (requise pour obtenir 95 % du gain maximal en pseudo-rendement) avec un rayonnement électromagnétique monochromatique, en fonction de l'irradiance E du rayonnement. Les différentes courbes correspondent à différentes longueurs d'onde : 400 nm, 800 nm, 1000 nm et 1100 nm.

Pour une même irradiance E, la durée de traitement de référence $t_{ref}$ diminue lorsque la longueur d'onde augmente. Ainsi, en se plaçant sur la courbe caractéristique correspondant à une longueur d'onde de 400 nm, on peut en déduire une durée de traitement maximale permettant d'optimiser le pseudo-rendement.

Pour une irradiance E du rayonnement électromagnétique 20 supérieure ou égale à 200 kW/m$^2$, cette durée maximale de traitement est d'environ 12 secondes ($t_{ref} = 12$ s à 400 nm, $t_{ref} = 6$ s à 800 nm, $t_{ref} = 4,9$ s à 1000 nm et $t_{ref} = 4,45$ s à 1100 nm).

La durée pendant laquelle l'empilement 10' est soumis au rayonnement électromagnétique 20, appelée ici durée de traitement t, est inférieure ou égale à 12 s, afin d'être compatible avec la cadence des lignes de production actuelles de cellules photovoltaïques à hétérojonction. Le procédé de traitement décrit en relation avec la figure 2 peut donc être intégré au procédé de fabrication des cellules photovoltaïques à hétérojonction sans limiter sa cadence de production.

Pour une irradiance E du rayonnement électromagnétique 20 supérieure ou égale à 300 kW/m$^2$, la durée de traitement t est avantageusement inférieure ou égale à 8 secondes ($t_{ref}$ = 8 s à 400 nm d'après l'abaque de la figure 4, $t_{ref}$ = 4 s à 800 nm, $t_{ref}$ = 3,3 s à 1000 nm et $t_{ref}$ = 3 s à 1100 nm).

L'étape d'exposition au rayonnement électromagnétique peut être continue, c'est-à-dire accomplie en une seule fois, si la durée de traitement t et l'irradiance E du rayonnement électromagnétique 20 sont telles que la température de l'empilement 10' ne dépasse pas 200 °C (avec éventuellement l'aide du système de refroidissement). Si la durée de traitement t et l'irradiance E du rayonnement sont telles que la température de l'empilement dépasse 200 °C, en l'absence de système de refroidissement ou en cas de système de refroidissement insuffisant, l'étape d'exposition peut être réalisée par séquences, c'est-à-dire décomposée en plusieurs phases d'exposition qui sont séparées par des phases de refroidissement (par convection naturelle ou forcée). La durée de traitement t est alors atteinte en n phases d'exposition de x secondes (*n* étant un entier naturel positif et *x* un nombre réel positif).

Dans un mode de mise en œuvre préférentiel du procédé de traitement, l'irradiance E du rayonnement électromagnétique 20 est supérieure ou égale à 1000 kW/m$^2$ et la durée de traitement t est avantageusement inférieure ou égale à 2,5 secondes ($t_{ref}$ = 2,5 s à 400 nm d'après l'abaque de la figure 4, $t_{ref}$ = 1,2 s à 800 nm, $t_{ref}$ = 0,98 s à 1000 nm et $t_{ref}$ = 0,9 s à 1100 nm).

Une durée d'exposition inférieure ou égale à 2,5 s permet de relâcher les contraintes sur la mise en œuvre du procédé, en particulier sur la gestion thermique de l'empilement 10'. Le silicium amorphe est en effet capable de supporter des températures élevées, bien supérieures à 200 °C, pendant des durées très courtes. Cela peut permettre de réaliser l'étape d'exposition en une seule fois, de réduire le nombre de phases dans le cas d'une étape d'exposition séquentielle ou d'utiliser un système de refroidissement moins performant (et donc moins coûteux).

Par exemple, le silicium amorphe de l'empilement 10' peut supporter une température d'environ 320 °C pendant 0,2 seconde environ (après quoi il subit des dommages irréversibles). Il peut donc être envisagé de réaliser l'étape d'exposition de façon séquentielle, avec des phases de durée égale à 0,2 s, si besoin en maintenant la température de l'empilement en dessous de 320 °C.

Une durée de traitement t supérieure à la durée de traitement de référence $t_{ref}$ pour une longueur d'onde et une irradiance donnée peut être bénéfique pour la cellule, car elle permet au gain en pseudo-rendement de dépasser 95 % du gain maximum.

On définit la durée de traitement minimale $t_{min}$ comme étant la durée d'exposition pour laquelle on obtient 50 % du gain maximum :

[Math 6]

$$Gain\ normalisé\ (t_{min}) = 0,5 = 1 - e^{-t_{min}/\tau}$$

Les équations [Math 2] et [Math 6] permettent d'aboutir à la relation suivante entre la durée de traitement de référence $t_{ref}$ et la durée de traitement minimale $t_{min}$ :

[Math 7]

$$\frac{t_{min}}{t_{ref}} = \frac{ln(0,5)}{ln(0,05)}$$

soit :

[Math 8]

$$t_{min} = 0,23 \times t_{ref}$$

Une durée de traitement t supérieure ou égale à la durée de traitement minimale $t_{min}$ (soit 23 % de la durée de traitement de référence $t_{ref}$, donnée par l'expressions [Math 4] ou [Math 5] selon le type de rayonnement électromagnétique) permet d'obtenir un gain en pseudo-rendement supérieur ou égal à 50 % de sa valeur maximale. Une durée de traitement t supérieure ou égale à la durée de traitement minimale $t_{min}$ et inférieure ou égale à la durée de traitement de référence $t_{ref}$ permet d'obtenir un gain en pseudo-rendement compris entre 50 % et 95 % de sa valeur maximale.

Le procédé de traitement décrit ci-dessus peut être accompli à différents stades de la fabrication d'une cellule photovoltaïque à hétérojonction de type n. Une cellule photovoltaïque à hétérojonction de type n désigne une cellule photovoltaïque à hétérojonction réalisée à partir d'un substrat en silicium cristallin dopé de type n. Cette cellule photovoltaïque peut être une cellule monofaciale ou bifaciale. Dans une cellule monofaciale, seule la face avant capte le rayonnement solaire. Dans une cellule bifaciale, les faces avant et arrière captent chacune une partie du rayonnement solaire. La face avant capte le rayonnement incident (i.e. direct) tandis que la face arrière capte le rayonnement diffus ou réfléchi. La face avant d'une cellule bifaciale est celle permettant d'obtenir le maximum de courant électrique lorsqu'elle est tournée vers le rayonnement incident. L'émetteur de la cellule photovoltaïque à hétérojonction de type n, c'est-dire la couche de silicium amorphe dopé de type p, peut être situé en face avant ou en face arrière de la cellule.

De manière générale, le procédé de fabrication d'une cellule photovoltaïque à hétérojonction de type n comprend (en référence à la figure 1) :

- le dépôt d'une première couche de passivation 14 en silicium amorphe hydrogéné (de préférence intrinsèque) sur une première face du substrat 11 ;
- le dépôt d'une première couche de silicium amorphe dopé (et de préférence hydrogéné) 12 sur la première couche de passivation 14 ;
- le dépôt d'une première couche d'oxyde transparent conducteur 15 sur la première couche de silicium amorphe dopé 12 ; et
- la formation d'au moins une électrode de collecte 16 sur la première couche d'oxyde transparent conducteur 15 ; et, lorsque la première couche de silicium amorphe 12 est dopée de type n ;
- le dépôt d'une deuxième couche de passivation 14 sur une deuxième face opposée du substrat 11 ;
- le dépôt d'une deuxième couche de silicium amorphe dopé p 13 (et de préférence hydrogéné) sur la deuxième couche de passivation 14.

La fabrication d'une cellule photovoltaïque bifaciale, telle que la cellule photovoltaïque 10 illustrée par la figure 1, comprend en outre le dépôt d'une deuxième couche d'oxyde transparent conducteur 15 sur la deuxième couche de silicium amorphe dopé 13 et la formation d'au moins une électrode de collecte 16 sur la deuxième couche d'oxyde transparent conducteur 15. L'une des deux première et deuxième couches de silicium amorphe 12-13 est dopée p et l'autre de ces couches 12-13 est dopée n.

Pour ne pas complexifier le procédé de fabrication de la cellule photovoltaïque en créant une étape supplémentaire, le procédé de traitement est avantageusement intégré à une étape déjà existante. Par exemple, l'empilement comprenant le substrat 11 et la première couche de passivation 14 peut être illuminé lors du dépôt de la première couche de silicium amorphe dopé 12 ou du dépôt de la deuxième couche de silicium amorphe dopé 13. De préférence, l'empilement est illuminé lors du dépôt de la couche de silicium amorphe dopé p (l'amélioration de la passivation étant plus sensible que lors du dépôt de la couche de silicium amorphe dopé n).

L'empilement peut être également illuminé lors du dépôt de la première couche d'oxyde transparent conducteur 15 sur la première couche de silicium amorphe dopé 12 ou, dans le cas d'une cellule bifaciale uniquement, lors du dépôt de la deuxième couche d'oxyde transparent conducteur 15 sur la deuxième couche de silicium amorphe dopé 13. L'interface entre chaque couche d'oxyde transparent conducteur et la couche de silicium amorphe dopé sous-jacente peut être ainsi améliorée.

L'empilement peut être également illuminé lors de la formation des électrodes de collecte 16 sur la première couche d'oxyde transparent conducteur 15 ou, dans le cas d'une cellule bifaciale uniquement, sur la deuxième couche d'oxyde transparent conducteur 15. La formation des électrodes de collecte 16 comprend généralement deux opérations :

- une première opération consistant à déposer par sérigraphie une pâte métallique sur la (première ou deuxième) couche d'oxyde transparent conducteur 15 ; et
- une deuxième opération consistant à durcir la pâte métallique, par exemple au moyen d'un traitement thermique, afin de diminuer la résistivité des électrodes de collecte (métalliques).

Cette deuxième opération de durcissement de la pâte métallique et l'étape d'illumination de l'empilement sont avantageusement accomplies simultanément. La chaleur produite par l'illumination contribue ainsi au durcissement de la pâte métallique.

Le procédé de traitement peut être également appliqué à une cellule photovoltaïque à hétérojonction dans son état final (après la formation des électrodes de collecte 16 sur la ou les couches d'oxyde transparent conducteur 15).

Une cellule photovoltaïque bifaciale peut être illuminée indifféremment par la face avant ou pas la face arrière. En effet, ni la couche d'oxyde transparent conducteur 15, ni les électrodes de collecte 16 (présentes en face avant et en face arrière de la cellule) ne font obstacle au rayonnement électromagnétique 20.

L'illumination d'une cellule photovoltaïque monofaciale s'effectue par la face avant, la cellule comprenant en face arrière une métallisation opaque qui occupe toute la surface ou un réseau d'électrodes suffisamment dense pour bloquer la majeure partie du rayonnement électromagnétique.

Dans le cadre de la fabrication de cellules dites « tandem » comprenant une première cellule à base de pérovskite (cellule dite « supérieure ») disposée sur une cellule à hétérojonction de silicium (cellule dite « inférieure »), il peut être également avantageux de traiter la cellule à hétérojonction avant le dépôt de la cellule pérovskite, à la fois pour améliorer les couches de passivation de la cellule à hétérojonction et pour améliorer la future interface entre les deux cellules. Dans ce cas, le procédé de traitement peut intervenir en fin de fabrication de la cellule à hétérojonction ou lors d'une des étapes de fabrication de la cellule à hétérojonction.

Alternativement, le procédé de traitement peut être appliqué après le dépôt de la cellule pérovskite sur la cellule à hétérojonction de silicium, à la condition de maintenir une température de traitement inférieure à 200 °C, de préférence inférieure ou égale à 150 °C.

Enfin, le procédé de traitement peut être appliqué également à une cellule photovoltaïque à hétérojonction au sein d'un module.

Un autre aspect de l'invention concerne donc un procédé de traitement d'un module photovoltaïque comprenant au moins deux cellules photovoltaïques à hétérojonction de silicium (SHJ) connectées électriquement entre elles. Chaque cellule SHJ comprend un substrat en silicium cristallin dopé de type n et une couche de passivation en silicium amorphe hydrogéné disposée sur une face du substrat. Les cellules SHJ du module photovoltaïque sont par exemple du type de la figure 1. Le procédé de traitement comprend une étape d'exposition des cellules SHJ à un rayonnement électromagnétique pendant une durée de traitement inférieure ou égale à 12 s, le rayonnement électromagnétique présentant une irradiance supérieure ou égale à 200 kW/m$^2$. Les cellules SHJ sont avantageusement maintenues à une température inférieure à 200 °C lors de l'étape d'exposition au rayonnement électromagnétique.

Un exemple de mise en œuvre du procédé de traitement va maintenant être décrit. Six cellules à hétérojonction de silicium 10 identiques à celle de la figure 1 ont été exposées pendant 3 secondes à un rayonnement électromagnétique d'une irradiance égale à 300 kW/m$^2$ et de longueur d'onde égale à 980 nm. L'exposition de chaque cellule est réalisée en effectuant plusieurs passages sous une tête laser (la somme des temps de passage valant 3 secondes).

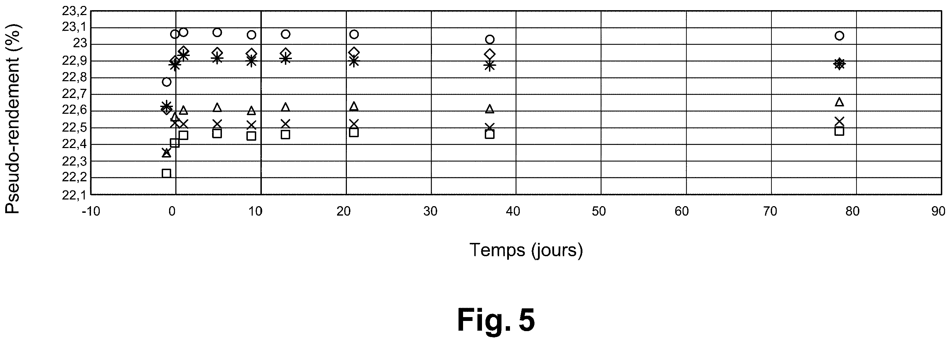

La figure 5, qui représente l'évolution du pseudo-rendement des six cellules photovoltaïques au cours du temps, montre un gain en pseudo-rendement d'environ 0,3 % absolu (visible à t<0) et que ce gain est stable sur une très longue période, ici près de 3 mois pendant lesquels les cellules ont été stockées dans l'obscurité.

## Revendications

1. Procédé de traitement d'un empilement (10') obtenu lors de la fabrication d'une cellule photovoltaïque à hétérojonction, l'empilement comprenant un substrat (11) en silicium cristallin dopé de type n et une couche de passivation (14) en silicium amorphe hydrogéné disposée sur une face (11a) du substrat (11), ledit procédé comprenant une étape d'exposition de l'empilement (10') à un rayonnement électromagnétique (20) pendant une durée de traitement (t) inférieure ou égale à 12 s, le rayonnement électromagnétique (20) présentant une irradiance (E) supérieure ou égale à 200 kW/m$^2$.

2. Procédé selon la revendication 1, dans lequel l'irradiance (E) du rayonnement électromagnétique (20) est supérieure ou égale à 1000 kW/m$^2$ et dans lequel la durée de traitement (t) est inférieure ou égale à 2,5 s.

3. Procédé selon l'une des revendications 1 et 2, dans lequel la durée de traitement (t) est inversement proportionnelle à l'irradiance (E).

4. Procédé selon l'une quelconque des revendications 1 à 3, dans lequel le rayonnement électromagnétique (20) est monochromatique et présente une longueur d'onde ($\lambda$) comprise entre 400 nm et 1100 nm, de préférence entre 800 nm et 1000 nm.

5. Procédé selon la revendication 4, dans lequel la durée de traitement (t) satisfait la relation suivante :

$$t \geq 0{,}23 \times \frac{1000}{E} \times \frac{980}{\lambda}$$

où $\lambda$ est la longueur d'onde du rayonnement électromagnétique (20) et E est l'irradiance du rayonnement électromagnétique.

**6.** Procédé selon la revendication 5, dans lequel la durée de traitement (t) satisfait en outre la relation suivante :

$$t \leq \frac{1000}{E} \times \frac{980}{\lambda}$$

**7.** Procédé selon l'une quelconque des revendications 1 à 3, dans lequel le rayonnement électromagnétique (20) comprend plusieurs composantes de longueur d'onde comprise entre 400 nm et 1100 nm, de préférence entre 800 nm et 1000 nm.

**8.** Procédé selon la revendication 7, dans lequel la durée de traitement (t) satisfait la relation suivante :

$$t \geq 0{,}23 \times \frac{1}{\sum_{i=1}^{n} \frac{E_i}{1000} \times \frac{\lambda_i}{980}}$$

où i un indice variant entre 1 et le nombre n de composantes du rayonnement électromagnétique (20), $\lambda_i$ est la longueur d'onde de la composante d'indice i et $E_i$ est l'irradiance de la composante d'indice i.

**9.** Procédé selon la revendication 8, dans lequel la durée de traitement (t) satisfait en outre la relation suivante :

$$t \leq \frac{1}{\sum_{i=1}^{n} \frac{E_i}{1000} \times \frac{\lambda_i}{980}}$$

**10.** Procédé selon l'une quelconque des revendications 1 à 9, dans lequel l'empilement (10') est maintenu à une température inférieure à 200 °C lors de l'étape d'exposition au rayonnement électromagnétique.

**11.** Procédé selon l'une quelconque des revendications 1 à 10, dans lequel l'étape d'exposition au rayonnement électromagnétique (20) est continue ou séquentielle.

**12.** Procédé selon l'une quelconque des revendications 1 à 9, dans lequel l'étape d'exposition au rayonnement électromagnétique (20) comprend une pluralité de phases d'exposition de durée inférieure ou égale à 0,2 s, séparées par des phases de refroidissement, et dans lequel l'empilement (10') est maintenu à une température inférieure ou égale à 320 °C lors de chacune des phases d'exposition.

**13.** Procédé de fabrication d'une cellule photovoltaïque à hétérojonction (10), comprenant les étapes suivantes :

- former un empilement (10') en déposant une couche de passivation (14) en silicium amorphe hydrogéné sur une face (11a) d'un substrat (11) en silicium cristallin dopé de type n ;
- traiter l'empilement (10') en accomplissant un procédé de traitement selon l'une quelconque des revendications 1 à 12.

**14.** Procédé selon la revendication 13, comprenant en outre une étape de dépôt d'une couche de silicium amorphe dopé (12) sur la couche de passivation (14).

**15.** Procédé selon la revendication 14, dans lequel l'empilement est exposé au rayonnement électromagnétique pendant le dépôt de la couche de silicium amorphe dopé (12).

**16.** Procédé selon la revendication 14, comprenant en outre une étape de dépôt d'une couche d'oxyde transparent conducteur (15) sur la couche de silicium amorphe dopé (12).

**17.** Procédé selon la revendication 16, dans lequel l'empilement (10') est exposé au rayonnement électromagnétique (20) pendant l'étape de dépôt de la couche d'oxyde transparent conducteur (15).

**18.** Procédé selon la revendication 16, comprenant en outre une étape de formation d'au moins une électrode (16) sur la couche d'oxyde transparent conducteur (15), l'étape de formation de ladite au moins une électrode (16) comprenant une opération de dépôt par sérigraphie d'une pâte métallique et une opération de durcissement de la pâte métallique, et dans lequel l'opération de durcissement de la pâte métallique et l'étape d'exposition au rayonnement électromagnétique (20) sont accomplies simultanément.

**Patentansprüche**

**1.** Verfahren zur Behandlung eines Stapels (10'), der bei der Herstellung einer Photovoltaikzelle mit Heteroübergang erhalten wird, wobei der Stapel ein Substrat (11) aus n-dotiertem kristallinem Silizium und eine Passivierungsschicht (14) aus hydriertem amorphem Silizium umfasst, die auf einer Seite (11a) des Substrats (11) angeordnet ist, wobei das Verfahren einen Schritt umfasst, bei dem der Stapel (10') einer elektromagnetischen Strahlung (20) während einer Behandlungsdauer (t) von weniger als oder gleich 12 s ausgesetzt wird, wobei die elektromagnetische Strahlung (20) eine Bestrahlungsstärke (E) von mehr als oder gleich 200 kW/m$^2$ aufweist.

**2.** Verfahren nach Anspruch 1, bei dem die Bestrahlungsstärke (E) der elektromagnetischen Strahlung (20) größer oder gleich 1000 kW/m$^2$ ist und bei dem die Behandlungsdauer (t) kleiner oder gleich 2,5 s ist.

**3.** Verfahren nach einem der Ansprüche 1 und 2, bei dem die Behandlungsdauer (t) umgekehrt proportional zur Bestrahlungsstärke (E) ist.

**4.** Verfahren nach einem der Ansprüche 1 bis 3, bei dem die elektromagnetische Strahlung (20) monochromatisch ist und eine Wellenlänge ($\lambda$) zwischen 400 nm und 1100 nm, vorzugsweise zwischen 800 nm und 1000 nm, aufweist.

**5.** Verfahren nach Anspruch 4, bei dem die Behandlungsdauer (t) die folgende Beziehung erfüllt:

$$t \geq 0,23 \times \frac{1000}{E} \times \frac{980}{\lambda}$$

wobei $\lambda$ die Wellenlänge der elektromagnetischen Strahlung (20) und E die Bestrahlungsstärke der elektromagnetischen Strahlung ist.

**6.** Verfahren nach Anspruch 5, bei dem die Behandlungsdauer (t) zusätzlich die folgende Beziehung erfüllt:

$$t \leq \frac{1000}{E} \times \frac{980}{\lambda}$$

**7.** Verfahren nach einem der Ansprüche 1 bis 3, bei dem die elektromagnetische Strahlung (20) mehrere Wellenlängenkomponenten zwischen 400 nm und 1100 nm, vorzugsweise zwischen 800 nm und 1000 nm, umfasst.

**8.** Verfahren nach Anspruch 7, bei dem die Behandlungsdauer (t) die folgende Beziehung erfüllt:

$$t \geq 0,23 \times \frac{1}{\sum_{i=1}^{n} \frac{E_i}{1000} \times \frac{\lambda_i}{980}}$$

wobei i ein Index ist, der zwischen 1 und der Anzahl n der Komponenten der elektromagnetischen Strahlung (20) variiert, wobei $\lambda_i$ die Wellenlänge der Komponente mit dem Index i ist und $E_i$ die Bestrahlungsstärke der Komponente mit dem Index i ist.

9. Verfahren nach Anspruch 8, bei dem die Behandlungsdauer (t) zusätzlich die folgende Beziehung erfüllt:

$$t \leq \frac{1}{\sum_{i=1}^{n} \frac{E_i}{1000} \times \frac{\lambda_i}{980}}$$

10. Verfahren nach einem der Ansprüche 1 bis 9, bei dem der Stapel (10') während des Schritts der Bestrahlung mit elektromagnetischer Strahlung auf einer Temperatur unter 200 °C gehalten wird.

11. Verfahren nach einem der Ansprüche 1 bis 10, bei dem der Schritt des Aussetzens elektromagnetischer Strahlung (20) kontinuierlich oder sequenziell ist.

12. Verfahren nach einem der Ansprüche 1 bis 9, bei dem der Schritt des Aussetzens elektromagnetischer Strahlung (20) mehrere Expositionsphasen von einer Dauer von weniger als oder gleich 0,2 s umfasst, die durch Kühlphasen voneinander getrennt sind, und wobei der Stapel (10') während jeder der Expositionsphasen auf einer Temperatur von weniger als oder gleich 320 °G gehalten wird.

13. Verfahren zur Herstellung einer Photovoltaikzelle mit Heteroübergang (10), die folgenden Schritte umfassend:

- Bilden eines Stapels (10') durch Aufbringen einer Passivierungsschicht (14) aus hydriertem amorphem Silizium auf eine Seite (11a) eines Substrats (11) aus n-dotiertem kristallinem Silizium;
- Behandeln des Stapels (10') durch Durchführen eines Behandlungsverfahrens gemäß einem der Ansprüche 1 bis 12.

14. Verfahren nach Anspruch 13, das zusätzlich einen Schritt zum Aufbringen einer Schicht aus dotiertem amorphem Silizium (12) auf die Passivierungsschicht (14) umfasst.

15. Verfahren nach Anspruch 14, bei dem der Stapel während des Aufbringens der dotierten amorphen Siliziumschicht (12) elektromagnetischer Strahlung ausgesetzt wird.

16. Verfahren nach Anspruch 14, das zusätzlich einen Schritt zum Aufbringen einer Schicht aus transparentem leitfähigem Oxid (15) auf die dotierte amorphe Siliziumschicht (12) umfasst.

17. Verfahren nach Anspruch 16, bei dem der Stapel (10') während des Schritts des Aufbringens der transparenten leitfähigen Oxidschicht (15) elektromagnetischer Strahlung (20) ausgesetzt wird.

18. Verfahren nach Anspruch 16, das außerdem einen Schritt zum Bilden mindestens einer Elektrode (16) auf der transparenten leitfähigen Oxidschicht (15) umfasst, wobei der Schritt zum Bilden der mindestens einen Elektrode (16) einen Siebdruckvorgang zum Aufbringen einer Metallpaste und einen Aushärtungsvorgang für die Metallpaste umfasst und wobei der Aushärtungsvorgang für die Metallpaste und der Schritt des Aussetzens elektromagnetischer Strahlung (20) gleichzeitig durchgeführt werden.

**Claims**

1. Method for treating a stack (10') obtained during the manufacture of a heterojunction photovoltaic cell, the stack comprising a substrate (11) of n-doped crystalline silicon and a passivation layer (14) of hydrogenated amorphous silicon disposed on a face (11a) of the substrate (11), said method comprising a step of exposing the stack (10') to electromagnetic radiation (20) during a treatment period (t) less than or equal to 12 s, the electromagnetic radiation (20) having an irradiance (E) greater than or equal to 200 kW/m$^2$.

2. Method according to claim 1, wherein the irradiance (E) of the electromagnetic radiation (20) is greater than or equal to 1000 kW/m$^2$ and wherein the treatment period (t) is less than or equal to 2.5 s.

3. Method according to one of claims 1 and 2, wherein the treatment period (t) is inversely proportional to the irradiance (E).

4. Method according to any of claims 1 to 3, wherein the electromagnetic radiation (20) is monochromatic and has a wavelength (λ) comprised between 400 nm and 1100 nm, preferably between 800 nm and 1000 nm.

5. Method according to claim 4, wherein the treatment period (t) satisfies the following relationship:

$$t \geq 0.23 \times \frac{1000}{E} \times \frac{980}{\lambda}$$

where λ is the wavelength of the electromagnetic radiation (20) and E is the irradiance of the electromagnetic radiation.

6. Method according to claim 5, wherein the treatment period (t) further satisfies the following relationship:

$$t \leq \frac{1000}{E} \times \frac{980}{\lambda}$$

7. Method according to any of claims 1 to 3, wherein the electromagnetic radiation (20) comprises several components with a wavelength comprised between 400 nm and 1100 nm, preferably between 800 nm and 1000 nm.

8. Method according to claim 7, wherein the treatment period (t) satisfies the following relationship:

$$t \geq 0.23 \times \frac{1}{\sum_{i=1}^{n} \frac{E_i}{1000} \times \frac{\lambda_i}{980}}$$

where i is an index that varies between 1 and the number n of components of the electromagnetic radiation (20), $\lambda_i$ is the wavelength of the component of index i and $E_i$ is the irradiance of the component of index i.

9. Method according to claim 8, wherein the treatment period (t) further satisfies the following relationship:

$$t \leq \frac{1}{\sum_{i=1}^{n} \frac{E_i}{1000} \times \frac{\lambda_i}{980}}$$

10. Method according to any of claims 1 to 9, wherein the stack (10') is maintained at a temperature less than 200 °C during the step of exposing to electromagnetic radiation.

11. Method according to any of claims 1 to 10, wherein the step of exposing to the electromagnetic radiation (20) is continuous or sequential.

12. Method according to any of claims 1 to 9, wherein the step of exposing to the electromagnetic radiation (20) comprises a plurality of phases of exposing with a period less than or equal to 0.2 s, separated by phases of cooling, and wherein the stack (10') is maintained at a temperature less than or equal to 320 °C during each one of the phases of exposure.

13. Method for manufacturing a heterojunction photovoltaic cell (10), comprising the following steps:

- forming a stack (10') by depositing a passivation layer (14) of hydrogenated amorphous silicon on a face (11a) of a substrate (11) of n-doped crystalline silicon;
- treating the stack (10') by implementing the method for treating according to any of claims 1 to 12.

14. Method according to claim 13, further comprising a step of depositing a doped amorphous silicon layer (12) on the passivation layer (14).

**15.** Method according to claim 14, wherein the stack is exposed to the electromagnetic radiation during the deposition of the doped amorphous silicon layer (12).

**16.** Method according to claim 14, further comprising a step of depositing a transparent conductive oxide layer (15) on the doped amorphous silicon layer (12).

**17.** Method according to claim 16, wherein the stack (10') is exposed to electromagnetic radiation (20) during the step of depositing the transparent conductive oxide layer (15).

**18.** Method according to claim 16, further comprising a step of forming at least one electrode (16) on the transparent conductive oxide layer (15), the step of forming said at least one electrode (16) comprising an operation of depositing by screen printing a metal paste and an operation of hardening the metal paste, and wherein the operation of hardening the metal paste and the step of exposing to the electromagnetic radiation (20) are accomplished simultaneously.

**Fig. 1**

**Fig. 2**

Fig. 3

Fig. 4

**Fig. 5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013001440 A

**Littérature non-brevet citée dans la description**

- **C. SUN et al.** Complete regeneration of BO-related defects in n-type upgraded metallurgical-grade Czochralski-grown silicon heterojunction solar cells. *Appl. Phys. Lett.*, 2018, vol. 113, 152105